Europäisches Patentamt

European Patent Office

Office européen des brevets

(11) Publication number: **0 053 402**
**B1**

# EUROPEAN PATENT SPECIFICATION

(45) Date of publication of patent specification: **26.10.88**

(21) Application number: **81110111.2**

(22) Date of filing: **03.12.81**

(51) Int. Cl.⁴: **H 01 L 31/04**

(54) pin photovoltaic cell having a hetero junction of amorphous siliconcompound and amorphous silicon.

(30) Priority: **03.12.80 JP 171375/80**
**19.12.80 JP 181150/80**
**29.01.81 JP 12313/81**
**17.02.81 JP 22690/81**

(43) Date of publication of application:
**09.06.82 Bulletin 82/23**

(45) Publication of the grant of the patent:
**26.10.88 Bulletin 88/43**

(84) Designated Contracting States:
**AT BE CH DE FR GB IT LI LU NL SE**

(56) References cited:
**WO-A-79/00776**
**GB-A-2 007 021**
**US-A-4 064 521**
**US-A-4 109 271**

**SOLAR CELLS, vol. 2, no. 3, 1980, Lausanne, L.
DALAL "Analysis of amorphous silicon solar
cells", p. 261-273**
**IEEE TRANSACTIONS ON ELECTRON
DEVICES, vol. ED-27, no. 4, April 1980, New
York, L. DALAL "Design Considerations for a-Si
Solar Cells", p. 662-670**

(73) Proprietor: **KANEGAFUCHI KAGAKU KOGYO
KABUSHIKI KAISHA**
**2-4 Nakanoshima 3-chome**
**Kita-ku Osaka-shi Osaka-fu (JP)**

(72) Inventor: **Hamakawa, Yoshihiro**
**3-17-4, Minamihanayashiki**
**Kawanishi-shi Hyogo-ken (JP)**
Inventor: **Tawada, Yoshihisa**
**14-39, Ooikemiyamadai Kita-Ku**
**Kobe-shi Hyogo-ken (JP)**

(74) Representative: **Vossius & Partner**
**Siebertstrasse 4 P.O. Box 86 07 67**
**D-8000 München 86 (DE)**

Courier Press, Leamington Spa, England.

## Description

Background of the invention

1. Field of the invention

This invention relates to a photovoltaic cell having a hetero junction of an amorphous semiconductor and amorphous silicon.

2. Description of the prior art

Amorphous silicon is obtained by the plasma decomposition of silane (SiH₄). W. E. Spear et al. discovered in 1976 that the conductivity of amorphous silicon could be notably altered by doping the substance with PH₃ or B₂H₆. D. E. Carlson et al. trially manufactured a solar cell using amorphous silicon in 1976. These achievements have drawn attention to amorphous silicon and have given an impetus to researches devoted to improvement of the conversion efficiency of a thin-film solar cell using amorphous silicon.

The researches have so far led to development of thin-film amorphous silicon photovoltaic cells of the Schottky barrier type, pin type, MIS type and hetero junction type. The first three of these types promise to provide highly efficient solar cells. The Schottky barrier type photovoltaic cell made by D. E. Carlson et al. in 1977 showed a conversion efficiency of 5.5%, the MIS type photovoltaic cell made by J. I. B. Wilson et al. in 1978 a conversion efficiency of 4.8% and the pin type photovoltaic cell made by Yoshihiro Hamakawa et. al in 1978 a conversion efficiency of 4.5% respectively.

In US—A—4109271 there is described a pin amorphous silicon and silicon carbide heterojunction photovoltaic cell. On the light incident side the cell is provided with a layer of amorphous silicon carbide having a bandgap energy in the range of 2.2 eV to 3.2 eV.

In the case of the pin junction type solar cell, the p or n type amorphous silicon gives a carrier a short life and, therefore, fails to provide an effective carrier and the p layer suffers from heavy absorption loss of light because it has a higher light absorption coefficient than the i layer.

The inverted pin type photovoltaic cell has been proposed with a view to overcoming these drawbacks. This cell is constructed so that the light impinges on the n type amorphous silicon side. Since this cell has a smaller light absorption coefficient than the p type, it is believed to be more advantageous, though slightly. Nevertheless this n type amorphous silicon is no better than the p type in the sense that it similarly suffers from absorption loss of light.

The inventors made a diligent study devoted to improvement of the efficiency of the pin type photovoltaic conversion. They consequently have found that the shortcircuit current and the open circuit voltage of the pin junction type photovoltaic cell are greatly improved by using in at least either one of the p and n layers of the cell a doped thin film of a p or n type amorphous semiconductor having an optical band gap of not less than about 1.85 eV, an electric conductivity of not less than about $10^{-8} (\Omega \cdot cm)^{-1}$ at 20°C and a diffusion potential, Vd, (exhibited in the pin junction) of not less than about 1.1 volts. The photovoltaic cell of this invention is useful as a photo-electromotive cell in solar cells, photoswitches and the like. Now, the invention will be described in detail below.

Brief description of the drawings

Figure 1(a) and 1(b) are structural diagrams illustrating a photovoltaic cell of the type wherein the light impinges on the p and on the n layer side respectively.

Figure 2 is a diagram representing an energy band profile of the hetero p-i-n junction photovoltaic cell of this invention.

Figure 3 is a graph showing the relation between the diffusion potential, Vd, and the open circuit voltage as obtained with the p type amorphous semiconductor on the window side.

Detailed description of the invention

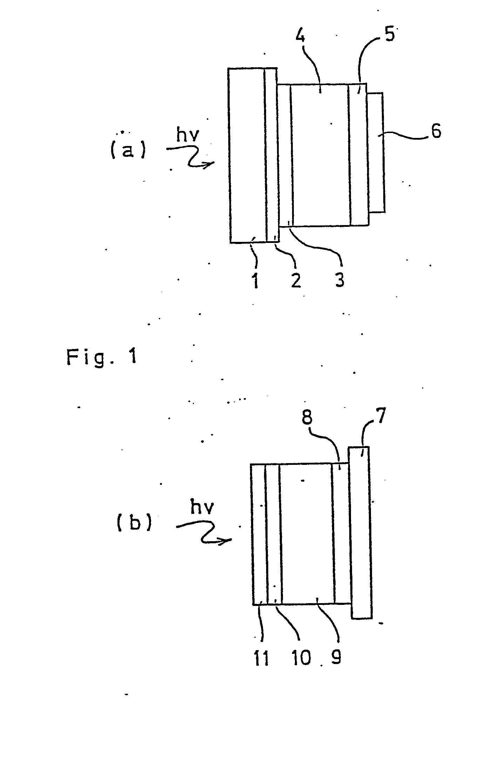

The cell of Figure 1 comprises a glass substrate 1, a transparent electrode 2, a p type amorphous semiconductor 3, a i type a-Si 4, an n type semiconductor 5 (such as of the n type a-Si) and an electrode 6. The cell of Figure 1b comprises an electrode substrate 7, a p type a-Si 8, an i type a-Si 9, an n type amorphous semiconductor 10 and a transparent electrode 11. The amorphous silicon of this invention is obtained by subjecting a mixed gas consisting of silane (SiH₄) or a derivative thereof, silane fluoride or a derivative thereof, or a mixture thereof and an inert gas such as hydrogen, argon diluted with hydrogen or helium, to radio-frequency glow discharge decomposition or DC glow discharge decomposition by the capacitive or inductive coupling method. The concentration of silane in the mixed gas generally is in the range of from 0.5 to 100%.

The substrate is desired to have a working temperature in the range of from 200 to 300°C. It comprises a glass sheet having a transparent electrode (such as of ITO and SnO₂) vacuum deposited thereon, a polymer film, a metal sheet and all other component layers indispensable to the construction of a solar cell.

Typical examples of the basic construction of a solar cell are shown in Figure 1(a), (b). Illustrated in (a) is the type wherein the light impinges on the p side. This type has a construction of Glass—transparent electrode—p-i-n—Al, for example. Illustrated in (b) is the type wherein the light impinges on the n side. This type has a construction of stainless steel—p-i-n—transparent electrode. Optionally, other constructions may be formed by interposing a thin insulation layer or a thin metal layer between the p layer and the transparent electrode. Any construction suffices so far as the p-i-n junction is included as the basic component.

The pin junction is constructed by forming an i layer of intrinsic amorphous silicon (hereinafter referred to as i type a-Si) obtained by the glow discharge decomposition of silane or a derivative thereof, silane fluoride or a derivative thereof or a mixture thereof and possessed of a carrier life of not less than about $10^{-7}$ second, a localized density of state of not more than about $10^{17}$ cm$^{-3}$eV$^{-1}$ and a mobility of not less than $10^{-3}$cm$^2$V·S and joining p and n type doped semiconductors to the i layer. The construction contemplated by this invention is characterized by using, in at least either one of the p and n layers, specifically in the layer on which the light impinges, a p or n type amorphous semiconductor having an optical band gap of not less than about 1.85 eV, an electric conductivity of not less than about $10^{-8}(\Omega \cdot cm)^{-1}$ at 20°C and a diffusion potential, Vd, (exhibited in the pin junction) of not less than about 1.1 volts. Optionally, the p or n type known amorphous semiconductors may be used one each in the p and n layers. The doped layer of a-Si which does not use the amorphous semiconductor of this invention may use an element of Group III of the Periodic Table of Elements for p type or an element of Group V of the same table for n type respectively in accordance with known techniques.

An amorphous semiconductor according to an embodiment of this invention comprises amorphous silicon carbide or amorphous silicon nitride represented by the general formula, a-Si$_{1-x}$C$_x$ or aSi$_{1-y}$N$_y$(x,y are each atomic fraction). These compounds are obtained by subjecting a hydrogen or fluorine compound of silicon and a hydrogen or fluorine compound of carbon or nitrogen to glow discharge decomposition.

Amorphous silicon carbide may be obtained by the plasma decomposition, or more preferably glow discharge decomposition, of a mixture of at least one gas selected from among silane, silicon fluoride and the derivatives thereof, and at least one gas selected from among hydrocarbons, alkylsilanes, the fluorides thereof and the derivatives thereof. For this purpose, it is possible to use a silicon compound with hydrogen and/or fluorine, including silane SiH$_4$, silane derivatives represented by the formula Si$_n$H$_{2n+2}$, derivatives of the formula SiF$_m$H$_{4-m}$ (m=1 to 4), and derivatives of the formula SiF$_m$H$_{2n+2-m}$. Examples of the applicable carbon compounds include tetra fluoro carbon CF$_4$, fluorohydrocarbon derivatives of the formula C$_n$F$_m$H$_{2n+2-m}$, and the unsaturated derivatives thereof. Examples of the suitable hydrocarbons include saturated apliphatic hydrocarbons (C$_n$H$_{2n+2}$), and unsaturated aliphatic hydrocarbons (C$_n$H$_{2n}$), such as ethylene and propylene. In other words, any hydrogen and/or fluorine derivative of silicon having vapor pressure may be used as a source of silicon for producing amorphous silicon carbide, and any hydrogen and/or fluorine derivative of carbon having vapor pressure may be used as a source of carbon. Among them methane is recommended to be employed in most preference. As to the preparation of amorphous silicon nitride the same discussion can be made as above except that in the referred compounds carbon must be replaced by nitrogen and that the preferred source of nitrogen is ammonia. The composition of silicon carbide is represented by the formula a-Si$_{1-x}$C$_x$ showing the ratio in number of silicon and carbon atoms in the film formed by glow discharge decomposition.

For example, the formula can be rewritten as a-Si$_{0.5}$C$_{0.5}$ if the numbers of carbon and silicon atoms in the film have a ratio of 1:1. The ratio of carbon and silicon atoms in the film can be determined by electron spectroscopy methods such as IMA, SIMS, AES, ESCA and other methods of electron spectroscopy. It should be noted that any amorphous semiconductor may be used on condition that it be possessed of an optical band gap of not less than about 1.85 eV, an electric conductivity of not less than about $10^{-8}(\Omega\ cm)^{-1}$ at 20°C and a diffusion potential, Vd, (exhibited in the pin junction) of not less than about 1.1 volts.

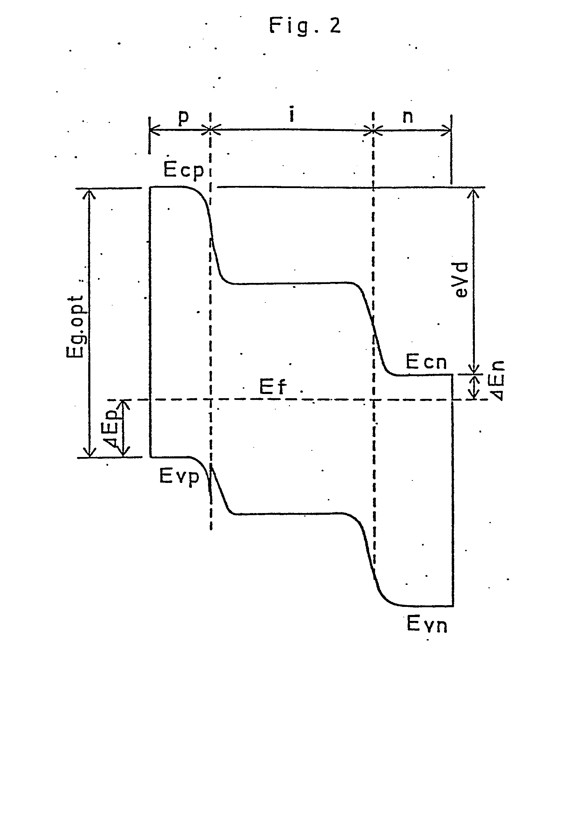

The amorphous semiconductor of the foregoing description, when used as the window material for the pin junction photovoltaic cell, has a large optical band gap and exhibits a very high open voltage, Voc, as well as the increase of the short-circuit current, Jsc. It has been found that in the photovoltaic cell of this invention, there exist the correlation between the diffusion potential, Vd and the open circuit voltage of the cell as depicted by the band profile of Figure 2. Although the diffusion potential, Vd, in the case of this invention exceeds about 1.1 volts, the trend of the relation is nearly constant without reference to the kind of the amorphous semiconductor to be used on the side exposed to the incident light. This diffusion potential is the difference obtained by subtracting activation energy $\Delta$Ep, $\Delta$En of the p, n doped layers from the optical band gap, Eg.opt, of the amorphous semiconductor on the side exposed to the light. Let Ecn stand for the 2 energy level of the conduction zone on and n side and Evp for the energy level of the valence electron zone on the p side, and the activating energies $\Delta$Ep and $\Delta$En which are shown in Figure 2 can be determined based on the dependency of electric conductivity on temperature. Since $\Delta$Ep=Ef−Evp holds for the p type and $\Delta$En=Ech−Ef for the n type, there ensues eVd=Eg.opt−($\Delta$Ep+$\Delta$En). In the case of the incidence of light which occurs on the n side, the diffusion potential is similarly obtained by subtracting the activation energy of the p, n layers from the optical band gap, Eg.opt, of the n type amorphous semiconductor.

This invention requires the optical band gap, Eg.opt, to lie between 1.85 eV and 2.15 eV, and the diffusion potential, Vd, to be at least about 1.1 volts. By incorporating an amorphous semiconductor which satisfies this requirement, the hetero junction photovoltaic cell is allowed to enjoy a great improvement in short-circuit current, Jsc, and open circuit voltage, Voc.

This invention further requires the electric conductivity to be at least $10^{-8}(\Omega \cdot cm)^{-1}$ at room

temperature. The reason for this lower limit is that below this limit, the fill factor, FF, becomes too small for the conversion efficiency to be practical.

Now, the hetero junction photovoltaic cell provided by this invention will be described specifically below. In one typical construction, this cell is composed of transparent electrode—p type amorphous semiconductor—i type a-Si—n type a-Si—electrode, with the transparent electrode side to be exposed to the incident light. The transparent electrode is desired to be formed of ITO or $SnO_2$, preferably the latter. It may be formed by having this substance vacuum deposited on a glass substrate or by having the substance directly vacuum deposited on the p type amorphous semiconductor. Amorphous silicon semiconductor to be employed for the present invention is doped for use in forming a p or n type semiconductor. The doping density may be controlled so as to provide an electric conductivity of at least on the order of $10^{-8}(\Omega \text{ cm})^{-1}$, preferably on the order of $10^{-7}(\Omega \text{ cm})^{-1}$ at room temperature. The doped semiconductor may usually contain about 0.001 to 10 atom %, and 0.005 to 2.0 atom %, of the Group III or the Group IV element. The doping method per se can be followed after a convenient glow discharge decomposition of the gas mixture comprising the Group III compounds such as diborane $(B_2H_6)$ or the Group V compounds such as phosphine mixed with other source materials.

The p type amorhpous semiconductor on the side of the cell exposed to the incident light is desired to have a thickness in the range of from about 3 to 30 nm (30 Å to 300 Å), preferably from 5 to 20 nm (50 Å to 200 Å). Although the thickness of the i type a-Si layer is not specifically limited in the cell of this invention, it is generally selected within the range of from about 250 to 1000 nm (2500 Å to 10000 Å). The n type a-Si layer whose primary function is to establish ohmic contact has no particular thickness limitation. Generally, the thickness of this layer is selected in the range of from about 15 to 60 nm (150 Å to 600 Å). Optionally, this n type a-Si layer may be substituted by an n type amorphous semiconductor of this invention.

In another typical construction, the cell is composed of transparent electrode—n type amorphous semiconductor—i type a-Si—p type a-Si—electrode, with the transparent electrode side to be exposed to the incident light. The n type amorphous semiconductor on the side of the cell exposed to the incident light is desired to have a thickness in the range of from about 3 to 30 nm (30 Å to 300 Å), preferably from 5 to 20 nm (50 Å to 200 Å). Although the thickness of the i type a-Si is not specifically limited, it is generally selected in the range of from about 250 to 1000 nm (2500 Å to 10000 Å). The thickness of the p type a-Si layer, which is not particularly limited either, is generally selected in the range of from about 15 to 60 nm (150 Å to 600 Å). Optionally, this p type a-Si layer may be substituted by a p type amorphous semiconductor of the present invention. The material for the transparent electrode and the method for the vacuum deposition thereof are the same as described above.

Now, the effect of this invention will be described below with reference to working examples. Glow discharge decomposition was performed at a high frequency of 14.56 MHz in a quartz test tube having an inside diameter of 11 cm. An i type a-Si was obtained by subjecting the silane diluted with hydrogen to the glow discharge decomposition at 267 to 1333 Pa (2 to 10 Torrs). An n type a-Si was obtained similarly by subjecting silane diluted with hydrogen and phosphine $(PH_3)$ $(PH_3/SiH_4=0.5 \text{ mol}\%)$ to the glow discharge decomposition. A p type $a-Si_{1-y}N_y$ was obtained similarly by subjecting silane, ammonia $(NH_3)$ and diborane $(B_2H_6)$ [B/(Si+N)=0.50 atom %] to the glow discharge decomposition. In this case, the gas composition involved in the glow discharge decomposition was adjusted so that the atomic fraction y in the formula, $a-Si_{1-y}N_y$, would fall in the range of from 0.75 to 0.05.

A solar cell was constructed by successively depositing the p type $a-Si_{1-y}N_y$, the i type a-Si and the n type a-Si in the order mentioned on the $SnO_2$ surface of a glass substrate coated with an $SnO_2$ film of 25 $\Omega/\square$ and finally vacuum depositing aluminum of 3.3 $mm^2$. This solar cell was tested for cell properties by use of a solar simulator of AM-1 (100 $mW/cm^2$). During the glow discharge, the temperature of the substrate was kept at 250°C. The thickness of the i layer was 500 nm (5000 Å), that of the n layer 50 nm (500 Å) and that of the p type $a-Si_{1-y}N_y$ layer 13.5 nm (135 Å).

The solar cell properties va. varying compositions of the p type $a-Si_{1-y}N_y$ film are shown in Table 1. It is seen from this table that the conversion efficiency (hereinafter represent by "η") which is 4.6% for the layer formed solely of silane $(Si_1N_0)$ is increased to 5.45%, 6.5% and 6.75 respectively when the value of "y" in the formula, $a-Si_{1-y}N_y$, of this invention is 0.05, 0.20 and 0.40, indicating that the n type amorphous semiconductor of this invention permits a conspicuous improvement in the value of η. It should be noted here that while the increase in the short-circuit current, Jsc, is naturally expected from the fact that the optical inhibition zone width of the $a-Si_{1-y}N_y$ is greater than that of the a-Si, the increase in the open circuit voltage, Voc, is quite beyond expectation. The conspicuous improvement in the conversion efficiency attained by this invention is due solely to the simultaneous improvement in these two factors.

The conversion efficiency begins to show a sign of decline as the value of "y" exceeds 0.5, because the increase in the resistance offered by the p type $a-Si_{1-y}N_y$ reaches a point where the fill factor (hereinafter referred to as FF) falls. In the meantime the short-circuit current (hereinafter referred to as Jsc) and the open circuit voltage (hereinafter referred to as Voc) remain substantially unaffected. The fulfilment of the requirement, $a-Si_{1-y}N_y$, is believed to lower the absorption loss of light in the p layer and enhance Jsc and Voc to an extent enough to permit the conspicuous improvement in the conversion efficiency.

Entirely the same results were obtained when $SiF_4$ and $NH_3$ were used instead.

Now, the p type $a-Si_{1-x}C_x$ will be described. The p type amorphous semiconductor $a-Si_{1-x}C_x$ in a varying composition was obtained by subjecting silane diluted with hydrogen, methane $(CH_4)$ and diborane

4

**0 053 402**

[B/(Si+C)=0.1 atom%] to the aforementioned glow discharge decomposition. Usually x of $a\text{-}Si_{1-x}C_x$ is 0.95 to 0.05 and in preference 0.55 to 0.05. Here one should pay attention to the electric conductivity of the product so that it may be not less than the order of $10^{-8}(\Omega \cdot cm)^{-1}$. Take an instance, silicon carbide having 2,2 eV of Eg. opt and $3\times10^{-9}(\Omega \cdot cm)^{-1}$ of electric conductivity shows only 2.9% of $\eta$. Thus, in usual cases, one of the measures for attaining the present electric conductivity is to make the Eg. opt less than 2.20 eV, more preferably less than 2.15 eV. The solar cell properties vs. varying compositions of the p type $a\text{-}Si_{1-x}C_x$ are shown in Table 2. The results reveal the conspicuous improvement brought about in Jsc and Voc. The value of "x" or "y" in the general formula $a\text{-}Si_{1-x}C_x$ or $a\text{-}Si_{1-y}N_y$ was obtained by the means of Auger electron spectroscopy. The value was calculated by

$$x=\frac{Ic/\alpha c}{Isi/\alpha si+Ic/\alpha c} \quad \text{or} \quad y=\frac{In/\alpha n}{Isi/\alpha si+In/\alpha n}$$

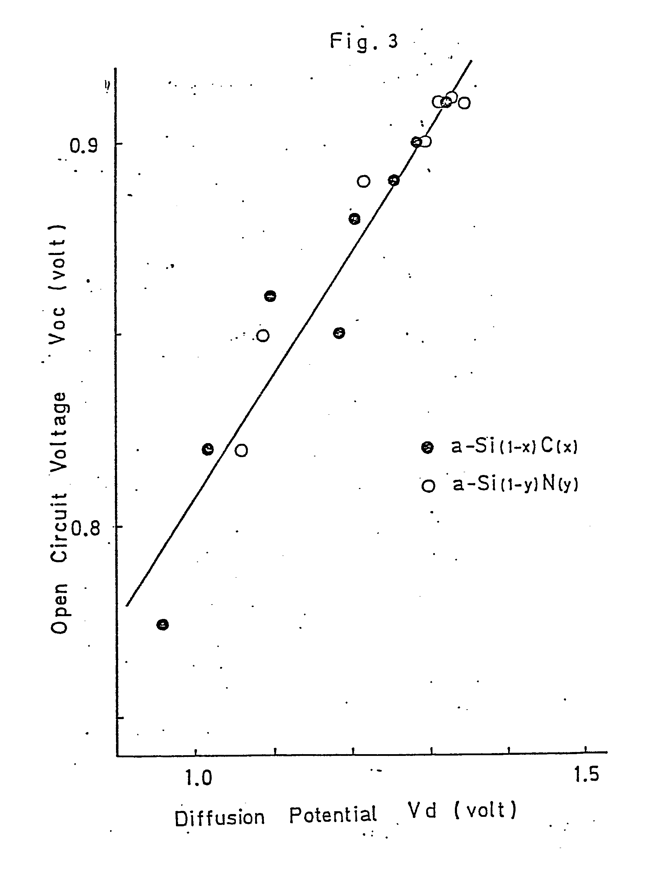

where Ic, In and Isi are the Auger peak heights of carbon, nitrogen and silicon respectively, $\alpha c$, $\alpha n$ and $\alpha si$ the relative Auger yields of carbon, nitrogen and silicon. Here $\alpha c=15$, $\alpha n=15$ and $\alpha si=65$ were adopted according to the data of "Auger electron spectroscopy reference manual" (edited by G. E. Mcguire, Plenum publishing Co., USA (1979). The values of the optical band gap, Eg. opt, of the $a\text{-}Si_{1-x}C_x$ and the $a\text{-}Si_{1-y}N_y$ are greater than the value of a-Si as shown in Tables 1, 2. Use of these amorphous semiconductors as window materials, therefore, is naturally expected to bring about an improvement in Jsc. Moreover, it brings about an unexpected conspicuous improvement in Voc, which leads to a great enhancement of the conversion efficiency. The reason therefor evidently exists in the relation between the diffusion potential, Vd, and Voc, which plots in one straight line without reference to the type of the amorphous semiconductor to be used, as shown in Figure 3. This means that the value of Voc linearly increases in proportion to the increase of Vd. This fact indicates that the diffusion potential is enhanced and Voc is proportionately improved by using an amorphous semiconductor of a large optical band gap as the material for the window of the pin junction photovoltaic cell.

As described above, this invention was issued from the discovery that the hetero junction photovoltaic cell which uses as the window material the amorphous semiconductor having an Eg. opt of at least about 1.85 eV and a pin junction diffusion potential, Vd, of at least 1.1 volts enjoys a conspicuous improvement in not only Jsc but also Voc. Surprisingly, this effect of the invention does not depend on the type of the amorphous semiconductor. The effect described above is entirely the same when the n type amorphous semiconductor of the cell is exposed to the incident light.

## TABLE 1

p type a-Si$_{(1-y)}$N$_{(y)}$/i-n a-Si:H

| Atomic fraction (y) | | 0 | 0.05 | 0.10 | 0.20 | 0.30 | 0.40 | 0.50 | 0.70 |
|---|---|---|---|---|---|---|---|---|---|
| Eg. opt (eV) | | 1.76 | 1.81 | 1.85 | 1.92 | 2.01 | 2.11 | 2.20 | 2.27 |
| Electric conductivity $(\Omega \cdot cm)^{-1}$ | | $5 \times 10^{-7}$ | $4 \times 10^{-7}$ | $5 \times 10^{-7}$ | $5 \times 10^{-7}$ | $3 \times 10^{-7}$ | $2 \times 10^{-7}$ | $1 \times 10^{-7}$ | $8 \times 10^{-8}$ |
| Ef—Ev (eV) | | 0.6 | 0.55 | 0.56 | 0.50 | 0.51 | 0.56 | 0.67 | 0.75 |
| Vd (volts) | | 0.96 | 1.06 | 1.09 | 1.22 | 1.30 | 1.35 | 1.33 | 1.32 |
| Solar cell properties | Jsc (mA/cm$^2$) | 10.3 | 10.8 | 11.2 | 11.6 | 11.9· | 12.15 | 12.1 | 12.2 |
| | Voc (volts) | 0.75 | 0.82 | 0.85 | 0.89 | 0.90 | 0.91 | 0.91 | 0.91 |
| | FF | 0.60 | 0.615 | 0.62 | 0.63 | 0.62 | 0.61 | 0.59 | 0.57 |
| | η (%) | 4.6 | 5.45 | 5.9 | 6.5 | 6.6 | 6.75 | 6.50 | 6.30 |

TABLE 2

p type a-Si$_{(1-x)}$C$_x$/i-n a-Si:H

| Atomic fraction (x) | | 0 | 0.05 | 0.1 | 0.2 | 0.3 | 0.4 | 0.5 | 0.7 | 0.85 |
|---|---|---|---|---|---|---|---|---|---|---|
| Eg. opt (eV) | | 1.76 | 1.80 | 1.85 | 1.95 | 2.06 | 2.10 | 2.11 | 2.10 | 2.09 |
| Electric conductivity $(\Omega \cdot cm)^{-1}$ | | $5\times10^{-7}$ | $7\times10^{-7}$ | $7\times10^{-7}$ | $1\times10^{-6}$ | $8\times10^{-7}$ | $6\times10^{-7}$ | $3\times10^{-7}$ | $2\times10^{-7}$ | $9\times10^{-8}$ |
| Ef—Ev (eV) | | 0.6 | 0.58 | 0.55 | 0.54 | 0.57 | 0.57 | 0.65 | 0.65 | 0.70 |
| Vd (volts) | | 0.96 | 1.02 | 1.10 | 1.21 | 1.29 | 1.33 | 1.26 | 1.25 | 1.19 |
| Solar cell properties | Jsc (mA/cm²) | 10.0 | 10.3 | 10.8 | 11.5 | 11.9 | 12.0 | 12.1 | 12.0 | 11.9 |
| | Voc (volts) | 0.75 | 0.82 | 0.86 | 0.88 | 0.90 | 0.91 | 0.89 | 0.885 | 0.85 |
| | FF | 0.61 | 0.64 | 0.68 | 0.70 | 0.67 | 0.66 | 0.66 | 0.62 | 0.58 |
| | η (%) | 4.6 | 5.4 | 6.3 | 7.1 | 7.18 | 7.2 | 7.1 | 6.6 | 5.9 |

i a-Si:H Eg.opt=1.8eV
n type a-Si:H Eg.opt=1.8eV
Ec—Ef=0.85eV
Ec—Ef=0.2eV.

## 0 053 402

**Claims**

1. A p-i-n amorphous silicon and silicon compound heterojunction photovoltaic cell, characterized by incorporating as either the p or n type side thereof exposed to the incident light an amorphous silicon compound having an optical band gap, (Eg. opt) between 1.85 eV and 2.15 eV, an electric conductivity of not less than $10^{-8}$ $(\Omega \cdot cm)^{-1}$ at 20°C and a p-i-n junction diffusion potential, Vd, of not less than 1.1 volts.

2. A photovoltaic cell according to claim 1, wherein the p or n side opposite to the side exposed to light is also formed of said amorphous silicon compound material.

3. A photovoltaic cell according to Claim 1 or 2, wherein the p or n type amorphous silicon compound is made of a substance represented by the general formula $a\text{-}Si_{1-x}C_x$ or $a\text{-}Si_{1-y}N_y$, respectively.

4. A photovoltaic cell according to claim 3, wherein the amorphous silicon compound satisfies the relationship $0.1 < x < 0.8$ or $0.1 < y < 0.8$ with respect to the general formula involved.

5. A photovoltaic cell according to any of claims 1 to 4 characterized in that the thickness of the p and/or the n type doped amorphous silicon compound layer exposed to the incident light is between 3 mm and 30 nm.

6. A photovoltaic cell as set forth in claim 5, wherein said p and/or n type doped layer exposed to the incident light has a thickness of 5 nm to 20 nm.

7. A photovoltaic cell according to any of claims 1 to 6, characterized in that the p and/or n type doped amorphous silicon compound layer exposed to the incident light has an electric conductivity of at least $10^{-7}$ $(\Omega \cdot cm)^{-1}$ at 20°C.

8. A photovoltaic cell as set forth in any of claims 3 or 5 to 7, as appendent to claim 3, characterized in that the atomic fraction x in said formula is between 0.10 and 0.95.

9. A photovoltaic cell as set forth in claim 8, characterized in that the atomic fraction x in said general formula is below 0.5.

10. A photovoltaic cell according to any of claims 1 to 9, characterized in that the p and/or the n type doped amorphous silicon compound layer is in ohmic contact with a transparent film electrode on the side exposed to light the incident.


**Patentansprüche**

1. Photovoltaische Zelle vom pin-Typ mit Heteroübergang zwischen amorphem Silicium und einer amorphen Siliciumverbindung, dadurch gekennzeichnet, daß entweder die p-Typ- oder die n-Typ-Seite, die dem einfallenden Licht ausgesetzt ist, als eine amorphe Siliciumverbindung vorgesehen wird, deren optischer Bandabstand (Eg. opt) von 1,85 eV bis 2,15 eV, deren elektrischen Leitfähigkeit mindestens $10^{-8}$ $(\Omega \cdot cm)^{-1}$ bei 20°C und deren pin-Übergangsdiffusionspotential Vd mindestens 1,1 Volt beträgt.

2. Photovoltaische Zelle nach Anspruch 1, dadurch gekennzeichnet, daß die p- oder n-Seite, die der dem Licht ausgesetzten Seite gegenüberliegt, ebenfalls aus Material der amorphen Siliciumverbindung hergestellt ist.

3. Photovoltaische Zelle nach Anspruch 1 oder 2, dadurch gekennzeichnet, daß die amorphe Siliciumverbindung des p- oder n-Typs hergestellt ist aus einer Substanz, die durch die allgemeine Formel $a\text{-}Si_{1-x}C_x$ bzw. $a\text{-}Si_{1-y}N_y$ wiedergegeben wird.

4. Photovoltaische Zelle nach Anspruch 3, dadurch gekennzeichnet, daß die allgemeine Formel für die amorphe Siliciumverbindung die Beziehung $0,1 < x < 0,8$ bzw. $0,1 < y < 0,8$ effüllt.

5. Photovoltaische Zelle nach einem der Ansprüche 1 bis 4, dadurch gekennzeichnet, daß die Dicke der dotierten Schicht aus der amorphen Siliciumverbindung vom p- und/oder n-Typ, die dem einfallenden Licht ausgesetzt ist, von 3 nm bis 30 nm beträgt.

6. Photovoltaische Zelle nach Anspruch 5, dadurch gekennzeichnet, daß die dotierte Schicht des p- und/oder n-Typs, die dem einfallenden Licht ausgesetzt ist, eine Dicke von 5 nm bis 20 nm aufweist.

7. Photovoltaische Zelle nach einem der Ansprüche 1 bis 6, dadurch gekennzeichnet, daß die dotierte Schicht des p- und/oder n-Typs aus der amorphen Siliciumverbindung, die dem einfallenden Licht ausgesetzt ist, eine elektrische Leitfähigkeit von mindestens $10^{-7}$ $(\Omega \cdot cm)^{-1}$ bei 20°C aufweist.

8. Photovoltaische Zelle nach einem der Ansprüche 3 oder 5 bis 7 in Abhängigkeit von Anspruch 3, dadurch gekennzeichnet, daß das Atomverhältnis x in der allgemeinen Formel von 0,10 bis 0,95 beträgt.

9. Photovoltaische Zelle nach Anspruch 8, dadurch gekennzeichnet, daß das Atomverhältnis x in der allgemeinen Formel unter 0,5 beträgt.

10. Photovoltaische Zelle nach einem der Ansprüche 1 bis 9, dadurch gekennzeichnet, daß die dotierte Schicht des p- und/oder n-Typs aus der amorphen Siliciumverbindung auf der dem einfallenden Licht zugewandten Seite in Ohm' schem Kontakt mit einer durchsichtigen Filmelektrode steht.


**Revendications**

1. Cellule photovoltaïque p-i-n à hétérojonction de silicium amorphe et de composé de silicium, caractérisée par l'incorporation, sous la forme de son côté de type p ou n exposé à la lumière incidente, d'un composé de silicium amorphe ayant un intervalle de bande optique (Eg. opt) se situant entre 1,85 eV et

8

2,15 eV, une conductivité électrique non inférieure à $10^{-8}$ $(\Omega \cdot cm)^{-1}$ à 20°C et un potentiel de diffusion de jonction p-i-n Vd non inférieur à 1,1 volt.

2. Cellule photovoltaïque suivant la revendication 1, caractérisée en ce que le côté p ou n opposé au côté exposé à la lumière est également formé de cette matière de composé de silicium amorphe.

3. Cellule photovoltaïque suivant l'une ou l'autre des revendications 1 et 2, caractérisée en ce que le composé de silicium amorphe de type p ou n est fait d'une substance représentée respectivement par la formule générale a-Si$_{1-x}$C$_x$ ou a-Si$_{1-y}$N$_y$.

4. Cellule photovoltaïque suivant la revendication 3, caractérisée en ce que le composé de silicium amorphe satisfait à la relation $0,1<x<0,8$ ou $0,1<y<0,8$ concernant la formule générale impliquée.

5. Cellule photovoltaïque suivant l'une quelconque des revendications 1 à 4, caractérisée en ce que l'épaisseur de la couche de composé de silicium amorphe dopée de type p et/ou n exposée à la lumière incidente se situe entre 3 nm et 30 nm.

6. Cellule photovoltaïque suivant la revendication 5, caractérisée en ce que la couche dopée de type p et/ou n exposée à la lumière incidente a une épaisseur de 5 nm à 20 nm.

7. Cellule photovoltaïque suivant l'une quelconque des revendications 1 à 6, caractérisée en ce que la couche de composé de silicium amorphe dopée de type p et/ou n exposée à la lumière indicente a une conductivité électrique d'au moins $10^{-7}$ $(\Omega \cdot cm)^{-1}$ à 20°C.

8. Cellule photovoltaïque suivant l'une quelconque des revendications 3 et 5 à 7, telle que reliée à la revendication 3, caractérisée en ce que la fraction atomique x dans la formule précitée se situe entre 0,10 et 0,95.

9. Cellule photovoltaïque suivant la revendication 8, caractérisée en ce que la fraction atomique x dans la formule générale précitée est en dessous de 0,5.

10. Cellule photovoltaïque suivant l'une quelconque des revendications 1 à 9, caractérisée en ce que la couche de composé de silicium amorphe dopée de type p et/ou n est en contact ohmique avec une électrode pelliculaire transparent du côté exposé à la lumière incidente.

0 053 402

Fig. 1

Fig. 2

Fig. 3